# EUROPEAN PATENT APPLICATION

(11) **EP 4 749 928 A1**
(43) Date of publication of application: **27.05.2026**
(21) Application number: 25214005.8
(22) Date of filing: 06.11.2025
(51) Int. Cl.: H03L 7/089, H03L 7/093

(54) **DUAL-PATH PHASE-LOCKED LOOP**

(30) Priority: 20.11.2024 IN 202441089954
(71) Applicant: NXP USA, Inc., Austin, TX 78735 (US)
(72) Inventor: Goyal, Saurabh, 5656AG Eindhoven (NL); Sinha, Anand Kumar, 5656AG Eindhoven (NL); Omer, Ateet, 5656AG Eindhoven (NL)
(74) Representative: Miles, John Richard

(57) **Abstract**

A dual-path phase-locked loop (PLL) is disclosed. The dual-path PLL converts, based on a masking value, a pulse signal to a masked pulse signal such that the masked pulse signal comprises one or more unmasked pulses and one or more masked pulses of the pulse signal. An integral current is generated, based on the masked pulse signal in a manner such that that an average current value of the integral current reaches a desired value over a predefined number of cycles of the pulse signal and an optimal peaking in the dual-path PLL is achieved.

## Description

### FIELD OF USE

The present disclosure relates generally to electronic circuits and, more particularly, to a dual-path phase-locked loop.

### BACKGROUND

A phase-locked loop (PLL) is typically included in an integrated circuit to generate a clock signal. The PLL generates the clock signal based on a reference signal that has a desired frequency and phase such that the clock signal has the desired frequency and phase. However, jitters in the clock signal cause deviation of the clock signal from the desired frequency and phase. Further, a high phase difference between the clock signal and the reference clock signal occurs based on the deviation. As a result, a performance of the integrated circuit degrades.

### BRIEF DESCRIPTION OF DRAWINGS

The following detailed description of the embodiments of the present disclosure will be better understood when read in conjunction with the appended drawings. The present disclosure is illustrated by way of example, and not limited by the accompanying figures, in which like references indicate similar elements.
FIG. 1 illustrates a block diagram of an integrated circuit (IC) in accordance with an embodiment of the present disclosure;
FIG. 2 illustrates a schematic block diagram of a pulse masking circuit of a dual-path phase-locked loop (PLL) of the IC of FIG. 1 in accordance with an embodiment of the present disclosure;
FIG. 3 represents a timing diagram that illustrates an operation of an up pulse masking circuit of the pulse masking circuit of FIG. 2 in accordance with an embodiment of the present disclosure; and
FIGS. 4A-4C, collectively, represents a flowchart that illustrates a method of operating the dual-path PLL of FIG. 2 in accordance with an embodiment of the present disclosure.

### DETAILED DESCRIPTION

The detailed description of the appended drawings is intended as a description of the embodiments of the present disclosure, and is not intended to represent the only form in which the present disclosure may be practiced. It is to be understood that the same or equivalent functions may be accomplished by different embodiments that are intended to be encompassed within the spirit and scope of the present disclosure.

### Overview:

In the realm of phase-locked loops (PLLs), a performance of the PLL is significantly affected by peaking (e.g., an increase in a gain of a closed-loop response of the PLL at specific frequencies). Peaking leads to an increased jitter in an output of the PLL. Such a phenomenon particularly occurs in a single-path PLL where the relationship between the peaking and a bandwidth of the PLL is interdependent. The peaking is further influenced by a damping factor of the PLL. For example, a low damping factor increases the peaking in the single-path PLL.

A conventional technique to enhance the damping factor is to increase a proportional gain of the single-path PLL. However, increasing the proportional gain inadvertently leads to the bandwidth being greater than one-twentieth of a reference frequency of the single-path PLL. Thus, a stability of the single-path PLL is affected. Consequently, high jitters occur in the output of the single-path PLL.

Dual-path PLLs have emerged as a viable solution to simultaneously address the above challenges by enabling independent control of the peaking and the bandwidth of the PLLs. A dual-path PLL includes an integral path to control the peaking in the PLL and a proportional path to control the bandwidth of the PLL. A damping factor of the dual-path PLL increases on reducing an integral gain (e.g., an integral charge pump gain) of the dual-path PLL. Thus, for a dual-path PLL, a significantly lower level of an integral current compared to a level of a proportional current is desired. For example, the integral current may be five times, ten times, fifteen times, or twenty times less than the proportional current.

To achieve varying current ranges for the integral and proportional currents, the integral charge pump is designed to have a lower current range whereas the proportional charge pump is designed to have a higher current range. However, such varying designs of the integral and proportional paths lead to a sub-threshold operation of the dual-path PLL. An operation of the dual-path PLL in a sub-threshold level may further lead to a spur in a control voltage of the PLL thereby resulting in increased jitters in a PLL output and compromising a performance and reliability of such PLLs.

Various embodiments of the present disclosure disclose a dual-path PLL. The dual-path PLL may include a phase-frequency detector that may generate a pulse signal based on a reference clock signal and a feedback clock signal. The dual-path PLL may further include a pulse masking circuit that may receive the pulse signal. The pulse masking circuit may convert the pulse signal to a masked pulse signal such that the masked pulse signal includes one or more unmasked pulses and one or more masked pulses of the pulse signal. The dual-path PLL may further include an integral charge pump to generate, based on the masked pulse signal, an integral current. The integral current may be generated in such a manner that an average current value of the integral current reaches a desired value over a predefined number of cycles of the pulse signal.

The integral charge pump disclosed in some embodiments of the present disclosure may operate in a higher current range (e.g., five times, ten times, fifteen times, or twenty times greater) in comparison to a conventional integral charge pump. Additionally, a proportional charge pump of the dual-path PLL may also operate in the same current range as that of the integral charge pump. As a result, a sub-threshold operation of the dual-path PLL is prevented.

The average value of the integral current over the predefined number of cycles of the pulse signal is in a lower current range (e.g., five times, ten times, fifteen times, or twenty times lower than a proportional current of the dual-path PLL). The average value of the integral current being in such a lower range leads to an optimal peaking in the dual-path PLL of the present disclosure. As a result, jitters are reduced in an output of the dual-path PLL in comparison to conventional dual-path PLLs. Further, a desired bandwidth of the dual-path PLL is achieved. Additionally, a requirement for a low integral charge pump gain to increase the damping factor is eliminated in the disclosed dual-path PLL.

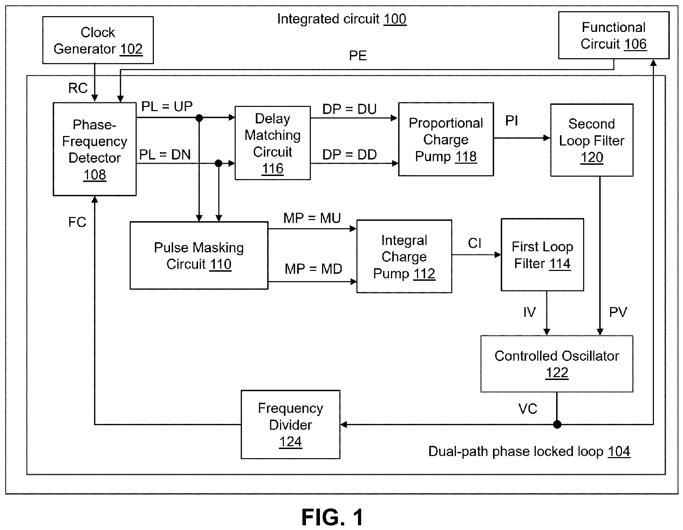

FIG. 1 illustrates a block diagram of an integrated circuit (IC) 100 in accordance with an embodiment of the present disclosure. The IC 100 may include a clock generator 102, a dual-path phase-locked loop (PLL) 104, and a functional circuit 106. The IC 100 may be utilized in automotive devices, networking devices, mobile devices, or the like.

### Clock generator 102:

The clock generator 102 may be coupled to the dual-path PLL 104. The clock generator 102 may include suitable circuitry that may be configured to perform one or more operations. For example, the clock generator 102 may be configured to generate and provide a reference clock signal RC to the dual-path PLL 104 for one or more operations. Examples of the clock generator 102 may include a crystal oscillator, a PLL clock generator, a resonator, or the like.

### Dual-path PLL 104:

The dual-path PLL 104 may be coupled to the clock generator 102 and the functional circuit 106. The dual-path PLL 104 may include a phase-frequency detector 108, a pulse masking circuit 110, an integral charge pump 112, a first loop filter 114, a delay matching circuit 116, a proportional charge pump 118, a second loop filter 120, a controlled oscillator 122, and a frequency divider 124. The dual-path PLL 104 may be configured to receive the reference clock signal RC from the clock generator 102. Further, the dual-path PLL 104 may be configured to receive a PLL enable signal PE. The dual-path PLL 104 may be further configured to generate a controlled oscillator clock signal VC based on the reference clock signal RC. The PLL enable signal PE may be a trigger to initiate the generation of the controlled oscillator clock signal VC, for the dual-path PLL 104.

The dual-path PLL 104 may include an integral path and a proportional path. The integral path may include the pulse masking circuit 110, the integral charge pump 112, and the first loop filter 114 whereas the proportional path may include the delay matching circuit 116, the proportional charge pump 118, and the second loop filter 120. The integral path may control peaking in the dual-path PLL 104 whereas the proportional path may control a bandwidth of the dual-path PLL 104.

### Phase-frequency detector 108:

The phase-frequency detector 108 may be coupled to the clock generator 102, the delay matching circuit 116, the pulse masking circuit 110, and the frequency divider 124. The phase-frequency detector 108 may include suitable circuitry that may be configured to perform one or more operations. For example, the phase-frequency detector 108 may be configured to receive the reference clock signal RC and a feedback clock signal FC, from the clock generator 102 and the frequency divider 124, respectively. The feedback clock signal FC may correspond to a frequency-divided version of the controlled oscillator clock signal VC. The phase-frequency detector 108 may be further configured to compare the feedback clock signal FC with the reference clock signal RC and generate a pulse signal PL based on the comparison. In other words, the phase-frequency detector 108 may compare at least one of a phase and a frequency of the feedback clock signal FC with at least one of a phase and a frequency of the reference clock signal RC, respectively. Further, the phase-frequency detector 108 may generate the pulse signal PL based on at least one of a phase difference and a frequency difference, between the reference clock signal RC and the feedback clock signal FC. Thus, the pulse signal PL may be indicative of at least one of the phase difference and the frequency difference between the reference clock signal RC and the feedback clock signal FC.

The pulse signal PL may include a plurality of pulses. Additionally, the pulse signal PL may correspond to an up pulse signal UP when the feedback clock signal FC lags the reference clock signal RC or to a down pulse signal DN when the feedback clock signal FC leads the reference clock signal RC. Thus, the pulse signal PL may correspond to the up pulse signal UP or the down pulse signal DN. The phase-frequency detector 108 may be further configured to output the pulse signal PL to the pulse masking circuit 110 and the delay matching circuit 116. In some embodiments, a frequency of the pulse signal PL may be in a range of 19.2 megahertz (MHz) to 25 MHz.

### Pulse masking circuit 110:

The pulse masking circuit 110 may be coupled to the phase-frequency detector 108 and the integral charge pump 112. The pulse masking circuit 110 may include suitable circuitry that may be configured to perform one or more operations. For example, the pulse masking circuit 110 may be configured to receive the pulse signal PL (e.g., the up pulse signal UP or the down pulse signal DN) from the phase-frequency detector 108. The pulse masking circuit 110 may be further configured to convert the pulse signal PL to a masked pulse signal MP based on a masking value. The masked pulse signal MP includes one or more unmasked pulses and one or more masked pulses, of the pulse signal PL.

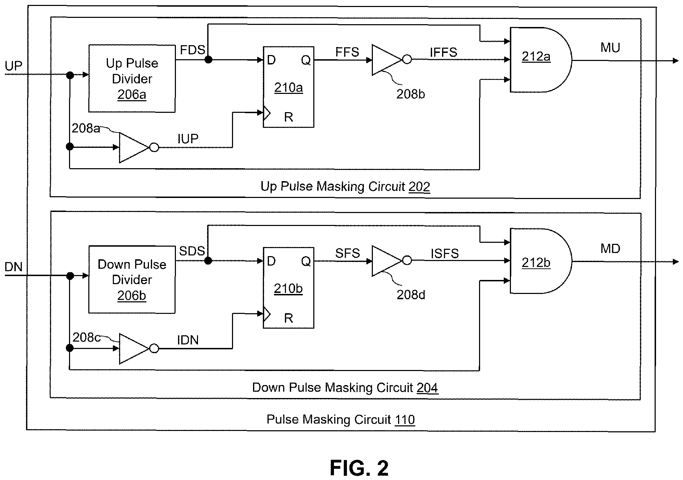

To convert the pulse signal PL to the masked pulse signal MP, the pulse masking circuit 110 may be further configured to mask one or more pulses of the pulse signal PL. Further, the masked pulse signal MP may correspond to a masked-up pulse signal MU or a masked-down pulse signal MD. In an example, when the pulse signal PL corresponds to the up pulse signal UP, the masked pulse signal MP corresponds to the masked-up pulse signal MU. Thus, the masked-up pulse signal MU includes one or more masked-up pulses and one or more unmasked-up pulses of the up pulse signal UP. In another example, when the pulse signal PL corresponds to the down pulse signal DN, the masked pulse signal MP corresponds to the masked-down pulse signal MD. Thus, the masked-down pulse signal MD includes one or more masked-down pulses and one or more unmasked-down pulses of the down pulse signal DN. The pulse masking circuit 110 may be further configured to provide the masked pulse signal MP to the integral charge pump 112. In various embodiments, the pulse masking circuit 110 may be implemented as a digital circuit. The structure and functioning of the pulse masking circuit 110 are further explained in detail in conjunction with FIG. 2.

### Integral charge pump 112:

The integral charge pump 112 may be coupled to the pulse masking circuit 110 and the first loop filter 114. The integral charge pump 112 may include suitable circuitry that may be configured to perform one or more operations. For example, the integral charge pump 112 may be configured to receive the masked pulse signal MP and generate, based on the masked pulse signal MP, an integral current CI.

The integral charge pump 112 may include a current source (not shown) and one or more transistors (not shown) to generate the integral current CI based on the masked pulse signal MP. The one or more transistors may be configured as one or more switches. For the sake of brevity, it is assumed that the integral charge pump 112 includes a first switch and a second switch. When the masked pulse signal MP corresponds to the masked-up pulse signal MU, the first switch is in an ON state and the second switch is in the OFF state, for a time interval associated with the one or more unmasked-up pulses. The integral charge pump 112 may source current from the current source to the first loop filter 114 when the first switch is in the ON state and the second switch is in the OFF state. The current sourced (alternatively referred to as, "a sourced current") from the current source to the first loop filter 114 corresponds to the integral current CI.

When the masked pulse signal MP corresponds to the masked-down pulse signal MD, the second switch is in an ON state and the first switch is in the OFF state, for a time interval associated with the one or more unmasked-down pulses. The integral charge pump 112 may drain the current from the first loop filter 114 when the second switch is in the ON state. The current drained (alternatively referred to as, "a drained current") from the first loop filter 114 corresponds to the integral current CI.

The integral charge pump 112 may generate the integral current CI such that an average value of the integral current CI may reach a desired value over a predefined number of cycles of the pulse signal PL (e.g., the up pulse signal UP or the down pulse signal DN) thereby controlling the peaking in the dual-path PLL 104. Further, the damping factor of the dual-path PLL 104 is determined based on an integral charge pump gain of the dual-path PLL 104. The integral charge pump gain may be further determined based on the average value of the integral current CI. Further, the integral charge pump gain of the dual-path PLL 104 may control the peaking in the dual-path PLL 104. Thus, the optimal peaking in the dual-path PLL 104 may be achieved by obtaining the desired average value of the integral current CI in the dual-path PLL 104. In conventional dual-path PLLs, the average value of the integral current of a dual-path PLL is based on a current rating of an integral charge pump. In an example, the average value of the integral current is desired to be less than (e.g., five times, ten times, fifteen times, or twenty times, lower than) a proportional current of the dual-path PLL to achieve optimal peaking in the dual-path PLLs. However, the designing of an integral charge pump with a lower current rating (e.g., five times, ten times, fifteen times, or twenty times, less than a current rating of a proportional charge pump of the dual-path PLL) leads to a current mismatch during sourcing and draining of the integral current thereby impacting the performance of the dual-path PLLs. The current mismatch may occur due to the one or more transistors of the integral charge pump operating in a sub-threshold region that may result in inaccurate draining and sourcing of the integral current and thereby lead to increased jitters in the controlled oscillator clock signal.

To overcome the above-described problems, in some embodiments of the present disclosure, the current rating of the current source in the integral charge pump 112 may be higher (e.g., five times, ten times, fifteen times, or twenty times greater) in comparison to conventional dual-path PLLs for mitigating a current mismatch. Further, based on the masking value of the pulse masking circuit 110, the average value of the integral current CI reaches the desired value over the predefined number of cycles of the plurality of pulses of the pulse signal PL. The average value of the integral current CI reaching the desired value over the predefined number of cycles results in the dual-path PLL 104 having a desired value of the integral charge pump gain.

In an example, the average value of the integral current CI over the predefined number of cycles is 600 nanoamperes (nA) and a current rating of the integral charge pump 112 to mitigate current mismatch is 3.6 microamperes (µA). In other words, when the current rating of the integral charge pump 112 is 3.6 µA, current mirroring in the one or more transistors in the integral charge pump 112 in the sub-threshold region is eliminated. Thus, the average value of the integral current CI over the predefined number of cycles is 600 nA. For the sake of brevity, it is assumed that the predefined number of cycles is 6 cycles of the pulse signal PL and each cycle includes 6 pulses. Further, the masking value is based on the predefined number of cycles and determined to be "3". In an example, when the predefined number of cycles is "N", the masking value is "N/2" to mask "N-1" pulses of the "N" pulses. Thus, when the predefined number of cycles is 6 cycles, the masking value is 6/2 = 3. The pulse masking circuit 110 masks 5 pulses out of the 6 pulses of the pulse signal PL. As a result, the masked pulse signal MP includes 1 unmasked pulse and 5 masked pulses for 6 cycles. Thus, the current source of the integral charge pump 112 may generate the integral current CI with a value of 3.6 µA for a single pulse out of the 6 pulses of each cycle of the pulse signal PL. As a result, the average value of the integral current CI over 6 cycles reaches a desired value of 600 nA thereby achieving optimal peaking in the dual-path PLL 104.

### First loop filter 114:

The first loop filter 114 may be coupled to the integral charge pump 112 and the controlled oscillator 122. The first loop filter 114 may include suitable circuitry that may be configured to perform one or more operations. For example, the first loop filter 114 may be configured to receive the integral current CI and filter the integral current CI. The first loop filter 114 may be further configured to output an integral control voltage IV based on the filtering of the integral current CI. The first loop filter 114 may output the integral control voltage IV to the controlled oscillator 122. In some embodiments, the first loop filter 114 may be implemented by a first capacitor. In some further embodiments, the first loop filter 114 may be a low pass filter.

### Delay matching circuit 116:

The delay matching circuit 116 may couple the phase-frequency detector 108 and the proportional charge pump 118. The delay matching circuit 116 may include suitable circuitry that may be configured to perform one or more operations. For example, the delay matching circuit 116 may be configured to receive the pulse signal PL from the phase-frequency detector 108 and delay the pulse signal PL. The delay matching circuit 116 may be further configured to output a delay matched pulse signal DP upon delaying the pulse signal. The delay matching circuit 116 may be further configured to output the delay matched pulse signal DP such that the proportional charge pump 118 receives the delay matched pulse signal DP when the integral charge pump 112 receives the masked pulse signal MP. Thus, one or more operations between the integral path and the proportional path of the dual-path PLL 104 are synchronized.

In some embodiments, when the pulse signal PL corresponds to the up pulse signal UP, the delay matching circuit 116 may delay the up pulse signal UP to output a delay matched up signal DU. Further, when the pulse signal PL corresponds to the down pulse signal DN, the delay matching circuit 116 may delay the down pulse signal DN to output a delay matched down signal DD. In some further embodiments, the delay matching circuit 116 may include one or more logic gates to delay the pulse signal PL. In further additional embodiments, the delay matching circuit 116 may include an AND gate that may be configured to delay the pulse signal PL. The AND gate may be coupled to a current source associated with the proportional charge pump 118 to receive one or more inputs. Additionally, the pulse signal PL is another input to the AND gate. Further, the AND gate may output the delay matched pulse signal DP based on the inputs.

### Proportional charge pump 118:

The proportional charge pump 118 may be coupled to the phase-frequency detector 108 by way of the delay matching circuit 116, and the second loop filter 120. The proportional charge pump 118 may include suitable circuitry that may be configured to perform one or more operations. For example, the proportional charge pump 118 may be configured to receive the delay matched pulse signal DP that may correspond to a delayed version of the pulse signal PL. The proportional charge pump 118 may be further configured to generate a proportional current PI based on the delay matched pulse signal DP. The bandwidth of the dual-path PLL 104 may be controlled based on the proportional current PI. In other words, the bandwidth may be determined based on a proportional gain of the dual-path PLL 104, and the proportional gain is determined based on the proportional current PI. When the proportional charge pump 118 receives the delay matched up signal DU as the delay matched pulse signal DP, the proportional charge pump 118 may source the proportional current PI to the second loop filter 120, in a similar manner as explained with reference to the integral charge pump 112. Further, when the proportional charge pump 118 receives the delay matched down signal DD as the delay matched pulse signal DP, the proportional charge pump 118 may drain the proportional current PI from the second loop filter 120. In further embodiments, a current rating of the proportional charge pump 118 may be identical to the current rating of the integral charge pump 112. The current rating of the proportional charge pump 118 being identical to the current rating of the integral charge pump 112 indicates that a difference between the current rating of the proportional charge pump 118 and the current rating of the integral charge pump 112 is within an acceptable margin. In an example, the acceptable margin may be between 0.1 µA to 5 µA. In further examples, the acceptable margin may be 0 µA.

### Second loop filter 120:

The second loop filter 120 may be coupled to the proportional charge pump 118 and the controlled oscillator 122. The second loop filter 120 may include suitable circuitry that may be configured to perform one or more operations. For example, the second loop filter 120 may be configured to receive the proportional current PI and filter the proportional current PI. The second loop filter 120 may be further configured to output a proportional control voltage PV based on the filtering of the proportional current PI. The second loop filter 120 may output the proportional control voltage PV to the controlled oscillator 122. In one example, the second loop filter 120 may be implemented by a resistor. In another example, the second loop filter 120 may be implemented by a resistor and a second capacitor. The first capacitor may have a higher capacitance value than the second capacitor.

### Controlled oscillator 122:

The controlled oscillator 122 may be coupled to the first loop filter 114, the second loop filter 120, the functional circuit 106, and the frequency divider 124. The controlled oscillator 122 may be a voltage-controlled oscillator. The controlled oscillator 122 may include suitable circuitry that may be configured to perform one or more operations. For example, the controlled oscillator 122 may be configured to receive the integral control voltage IV from the first loop filter 114 and the proportional control voltage PV from the second loop filter 120. The controlled oscillator 122 may be further configured to generate the controlled oscillator clock signal VC based on the integral control voltage IV and the proportional control voltage PV to minimize the phase difference between the feedback clock signal FC and the reference clock signal RC. The controlled oscillator 122 may receive the integral control voltage IV and the proportional control voltage PV based on the filtering of the integral current CI and the proportional current PI, respectively. The controlled oscillator 122 may be further configured to provide the controlled oscillator clock signal VC to the functional circuit 106 and the frequency divider 124. In additional embodiments, the controlled oscillator 122 may include a voltage-to-current converter that may be configured to combine the proportional control voltage PV and the integral control voltage IV to generate a controlled clock voltage. The controlled oscillator 122 may generate the controlled oscillator clock signal VC based on the controlled clock voltage.

### Frequency divider 124:

The frequency divider 124 may be coupled to the phase-frequency detector 108 and the controlled oscillator 122. The frequency divider 124 may include suitable circuitry that may be configured to perform one or more operations. For example, the frequency divider 124 may be configured to receive the controlled oscillator clock signal VC. The frequency divider 124 may be further configured to divide a frequency of the controlled oscillator clock signal VC by a division factor of the frequency divider 124. The frequency divider 124 may be further configured to generate the feedback clock signal FC based on the division of the frequency of the controlled oscillator clock signal VC. The frequency divider 124 may generate the feedback clock signal FC such that a frequency of the feedback clock signal FC and a frequency of the reference clock signal RC may be identical and an optimal operation of the dual-path PLL 104 is achieved. The frequency divider 124 may be further configured to provide the feedback clock signal FC to the phase-frequency detector 108. In an example, the frequency of the controlled oscillator clock signal VC is 800 MHz and the division factor is 8. As a result, the frequency of the feedback clock signal FC is 100 MHz.

The functional circuit 106 may be coupled to the dual-path PLL 104 (e.g., the phase-frequency detector 108 and the controlled oscillator 122). The functional circuit 106 may include suitable circuitry that may be configured to perform one or more operations. For example, the functional circuit 106 may be configured to generate and provide the PLL enable signal PE to the phase-frequency detector 108. The functional circuit 106 may be further configured to receive the controlled oscillator clock signal VC from the controlled oscillator 122 and perform one or more functional operations associated therewith based on the controlled oscillator clock signal VC. Examples of the functional circuit 106 may include frequency synthesizers, frequency modulators, frequency demodulators, clock recovery circuits, tone decoders, a memory, a sensor, an input/output circuit, a processor, a communications circuit, or the like. Further, the functional circuit 106 may be one of an analog circuit, a digital circuit, or any combination thereof.

FIG. 2 illustrates a schematic block diagram of the pulse masking circuit 110 in accordance with an embodiment of the present disclosure. The pulse masking circuit 110 may include an up pulse masking circuit 202 and a down pulse masking circuit 204.

### Up pulse masking circuit 202:

The up pulse masking circuit 202 may be coupled to the phase-frequency detector 108 and the integral charge pump 112. The up pulse masking circuit 202 may include suitable circuitry that may be configured to perform one or more operations. For example, the up pulse masking circuit 202 may be configured to receive the up pulse signal UP from the phase-frequency detector 108. The up pulse masking circuit 202 may be further configured to convert, based on the masking value, the up pulse signal UP to the masked-up pulse signal MU. The masked-up pulse signal MU includes one or more unmasked-up pulses of the up pulse signal UP and one or more masked-up pulses of the up pulse signal UP.

To convert the up pulse signal UP to the masked-up pulse signal MU, the up pulse masking circuit 202 may be further configured to mask one or more up pulses of the up pulse signal UP based on the masking value. The up pulse masking circuit 202 may include an up pulse divider 206a, a first inverter 208a, a first flip-flop 210a, a second inverter 208b, and a first logic gate 212a.

### Up pulse divider 206a:

The up pulse divider 206a may be coupled to the phase-frequency detector 108 and the first logic gate 212a. The up pulse divider 206a may be associated with the masking value. The masking value is obtained based on the predefined number of cycles of the pulse signal PL. In some embodiments, when the predefined number of cycles is "N", the masking value is "N" divided by "2". In an example, when the predefined number of cycles is "6", the masking value is "3". In another example, when the predefined number of cycles is in a range of "16-31", the masking value may be between "2-31".

The up pulse divider 206a may include suitable circuitry that may be configured to perform one or more operations. For example, the up pulse divider 206a may be configured to receive the up pulse signal UP. Further, the up pulse divider 206a may be configured to generate a first divider signal FDS based on the up pulse signal UP and the masking value. The first divider signal FDS corresponds to a frequency divided version of the up pulse signal UP. The up pulse divider 206a may be further configured to output the first divider signal FDS to the first flip-flop 210a and the first logic gate 212a. A logic state of the first divider signal FDS may alternate between an asserted state and a de-asserted state for every "N/2" cycles of the up pulse signal UP based on the masking value to generate the frequency divided version of the up pulse signal UP. In reference to the above example, when the masking value is "3", a logic state of the first divider signal FDS may alternate between an asserted state and a de-asserted state every 3 cycles of the up pulse signal UP. In further embodiments, the up pulse divider 206a may include one or more multiplexers that may tune the up pulse divider 206a to the masking value.

### First inverter 208a:

The first inverter 208a may be coupled to the phase-frequency detector 108 and the first flip-flop 210a. The first inverter 208a may include suitable circuitry that may be configured to perform one or more operations. For example, the first inverter 208a may be configured to receive the up pulse signal UP from the phase-frequency detector 108. The first inverter 208a may be further configured to invert the up pulse signal UP and output an inverted up pulse signal IUP based on inverting the up pulse signal UP. The first inverter 208a may output the inverted up pulse signal IUP to the first flip-flop 210a. Although not shown, the first inverter 208a may receive supply voltages at supply terminals thereof for performing the corresponding inversion operation. Examples of the first inverter 208a may include but are not limited to, a logical NOT gate, a complementary metal-oxide-semiconductor (CMOS) inverter, or the like.

### First flip-flop 210a:

The first flip-flop 210a may be coupled to the up pulse divider 206a, the first inverter 208a, and the second inverter 208b. The first flip-flop 210a may include suitable circuitry that may be configured to perform one or more operations. For example, the first flip-flop 210a may be configured to receive the first divider signal FDS as a data input from the up pulse divider 206a and the inverted up pulse signal IUP from the first inverter 208a as a clock input. The first flip-flop 210a may be further configured to output a first flop signal FFS such that the first flop signal FFS may be asserted based on a rising edge of the inverted up pulse signal IUP and the asserted state of the first divider signal FDS. Examples of the first flip-flop 210a may include but are not limited to, a D flip-flop, JK flip-flop, T flip-flop, or the like.

### Second inverter 208b:

The second inverter 208b may be coupled to the first flip-flop 210a and the first logic gate 212a. The second inverter 208b may include suitable circuitry that may be configured to perform one or more operations. For example, the second inverter 208b may be configured to receive the first flop signal FFS. The second inverter 208b may be further configured to invert the first flop signal FFS and output an inverted first flop signal IFFS based on inverting the first flop signal FFS. Although not shown, the second inverter 208b may receive supply voltages at supply terminals thereof for performing the corresponding inversion operation. Examples of the second inverter 208b may include but are not limited to, a logical NOT gate, a CMOS inverter, or the like.

### First logic gate 212a:

The first logic gate 212a may be coupled to the up pulse divider 206a, the second inverter 208b, and the phase-frequency detector 108. The first logic gate 212a may include suitable circuitry that may be configured to perform one or more operations. For example, the first logic gate 212a may be configured to receive the up pulse signal UP from the phase-frequency detector 108, the first divider signal FDS from the up pulse divider 206a, and the inverted first flop signal IFFS from the second inverter 208b, as inputs. The first logic gate 212a may be further configured to perform an AND operation on the inputs. The first logic gate 212a may be further configured to output the masked-up pulse signal MU based on the AND operation. The first logic gate 212a may be further configured to provide the masked-up pulse signal MU to the integral charge pump 112. Examples of the first logic gate 212a may include but are not limited to, a bipolar junction transistor (BJT) AND gate, a CMOS AND gate, a combination of NAND gates, a combination of any digital logic gates, or the like. In further embodiments, the first logic gate 212a may be any digital logic that may be accomplished with any combination of gates.

### In operation:

The up pulse divider 206a may generate the first divider signal FDS by dividing a frequency of the up pulse signal UP by the masking value. Additionally, the first inverter 208a may receive and invert the up pulse signal UP and output the inverted up pulse signal IUP. Further, the first flip-flop 210a may receive the first divider signal FDS as the data input and the inverted up pulse signal IUP as the clock input. The first flip-flop 210a may further output the first flop signal FFS that corresponds to a delayed version of the first divider signal FDS. The second inverter 208b may invert the first flop signal FFS and output the inverted first flop signal IFFS. Further, the first logic gate 212a may perform the AND operation on the up pulse signal UP, the first divider signal FDS, and the inverted first flop signal IFFS. In an example, when the up pulse signal UP, the first divider signal FDS, and the inverted first flop signal IFFS are asserted for a first time period, the first logic gate 212a asserts the masked-up pulse signal MU for the first time period. Further, for a second time period, when at least one of the up pulse signal UP, the first divider signal FDS, and the inverted first flop signal IFFS is de-asserted, the first logic gate 212a de-asserts the masked-up pulse signal MU for the second time period. In a third time period, when the up pulse signal UP, the first divider signal FDS, and the inverted first flop signal IFFS are asserted again, the first logic gate 212a asserts the masked-up pulse signal MU in the third time period. Thus, the one or more up pulses of the up pulse signal UP are masked in the second time period. To summarize, the up pulse divider 206a, the first inverter 208a, the first flip-flop 210a, the second inverter 208a, and the first logic gate 212a operate in conjunction to mask the one or more up pulses of the up pulse signal UP.

### Down pulse masking circuit 204:

The down pulse masking circuit 204 may be coupled to the phase-frequency detector 108 and the integral charge pump 112. The down pulse masking circuit 204 may include suitable circuitry that may be configured to perform one or more operations. For example, the down pulse masking circuit 204 may be configured to receive the down pulse signal DN. The down pulse masking circuit 204 may be further configured to convert, based on the masking value, the down pulse signal DN to the masked-down pulse signal MD. The masked-down pulse signal MD includes one or more masked-down pulses and one or more unmasked-down pulses of the pulse signal PL. The down pulse masking circuit 204 may include a down pulse divider 206b, a third inverter 208c, a second flip-flop 210b, a fourth inverter 208d, and a second logic gate 212b.

### Down pulse divider 206b:

The down pulse divider 206b may be coupled to the phase-frequency detector 108, the second flip-flop 210b, and the second logic gate 212b. The down pulse divider 206b may include suitable circuitry that may be configured to perform one or more operations. For example, the down pulse divider 206b may be configured to receive the down pulse signal DN. Further, the down pulse divider 206b may be configured to generate a second divider signal SDS based on the down pulse signal DN and the masking value. The masking value as previously explained is based on the predefined number of cycles of the pulse signal PL. Thus, when the predefined number of cycles is "N", the masking value is "N" divided by "2". The second divider signal SDS corresponds to a frequency divided version of the down pulse signal DN. A logic state of the second divider signal SDS may alternate between an asserted state and a de-asserted state for every "N/2" cycles of the down pulse signal DN based on the masking value, to generate the frequency divided version of the down pulse signal DN. In an example, when the masking value is "3", a logic state of the second divider signal SDS may thus alternate between an asserted state and a de-asserted state every 3 cycles of the down pulse signal DN. The down pulse divider 206b may be further configured to output the second divider signal SDS to the second flip-flop 210b and the second logic gate 212b.

### Third inverter 208c:

The third inverter 208c may be coupled to the phase-frequency detector 108 and the second flip-flop 210b. The third inverter 208c may include suitable circuitry that may be configured to perform one or more operations. For example, the third inverter 208c may be configured to receive the down pulse signal DN from the phase-frequency detector 108. The third inverter 208c may be further configured to invert the down pulse signal DN and output an inverted down pulse signal IDN. The third inverter 208c may output the inverted down pulse signal IDN to the second flip-flop 210b. Although not shown, the third inverter 208c may receive supply voltages at supply terminals thereof for performing the corresponding inversion operation. Examples of the third inverter 208c may include but are not limited to, a logical NOT gate, a CMOS inverter, or the like.

### Second flip-flop 210b:

The second flip-flop 210b may be coupled to the down pulse divider 206b, the third inverter 208c, and the fourth inverter 208d. The second flip-flop 210b may include suitable circuitry that may be configured to perform one or more operations. For example, the second flip-flop 210b may be configured to receive the second divider signal SDS as a data input from the down pulse divider 206b and the inverted down pulse signal IDN from the third inverter 208c as a clock input. The second flip-flop 210b may be further configured to output a second flop signal SFS such that the second flop signal SFS may be asserted based on a rising edge of the inverted down pulse signal IDN and the asserted state of the second divider signal SDS. Examples of the second flip-flop 210b may include but are not limited to, a D flip-flop, JK flip-flop, T flip-flop, or the like.

### Fourth inverter 208d:

The fourth inverter 208d may be coupled to the second flip-flop 210b and the second logic gate 212b. The fourth inverter 208d may include suitable circuitry that may be configured to perform one or more operations. For example, the fourth inverter 208d may be configured to receive the second flop signal SFS. The fourth inverter 208d may be further configured to invert the second flop signal SFS and output an inverted second flop signal ISFS. Although not shown, the fourth inverter 208d may receive supply voltages at supply terminals thereof for performing the corresponding inversion operation. Examples of the fourth inverter 208d may include but are not limited to, a logical NOT gate, a CMOS inverter, or the like.

### Second logic gate 212b:

The second logic gate 212b may be coupled to the down pulse divider 206b, the fourth inverter 208d, and the phase-frequency detector 108. The second logic gate 212b may include suitable circuitry that may be configured to perform one or more operations. For example, the second logic gate 212b may be configured to receive the down pulse signal DN from the phase-frequency detector 108, the second divider signal SDS from the down pulse divider 206b, and the inverted second flop signal ISFS from the fourth inverter 208d as inputs. The second logic gate 212b may be configured to perform an AND operation based on the inputs. The second logic gate 212b may be configured to output the masked-down pulse signal MD based on the AND operation. The second logic gate 212b may be further configured to provide the masked-down pulse signal MD to the integral charge pump 112. Examples of the second logic gate 212b may include but are not limited to, a BJT AND gate, a CMOS AND gate, a combination of NAND gates, a combination of any digital logic gates, or the like. In further embodiments, the second logic gate 212b may be any digital logic that may be accomplished with any combination of gates.

### In operation:

The down pulse divider 206b may generate the second divider signal SDS by dividing a frequency of the down pulse signal DN by the masking value. Additionally, the third inverter 208c may invert the down pulse signal DN. Further, the second flip-flop 210b may receive the second divider signal SDS as the data input and the inverted down pulse signal IDN as the clock input. The second flip-flop 210b may further output the second flop signal SFS that corresponds to a delayed version of the second divider signal SDS. The fourth inverter 208d may invert the second flop signal SFS and output the inverted second flop signal ISFS. Further, the second logic gate 212b may perform the AND operation on the down pulse signal DN, the second divider signal SDS, and the inverted second flop signal ISFS thereby masking the one or more down pulses of the down pulse signal DN. In an example, when the down pulse signal DN, the second divider signal SDS, and the inverted second flop signal ISFS are asserted for a first time period, the second logic gate 212b asserts the masked-down pulse signal MD for the first time period. Further, for a second time period, when at least one of the down pulse signal DN, the second divider signal SDS, and the inverted second flop signal ISFS is de-asserted, the second logic gate 212b de-asserts the masked-down pulse signal MD for the second time period. In a third time period, when the down pulse signal DN, the second divider signal SDS, and the inverted second flop signal ISFS are asserted again, the second logic gate 212b asserts the masked-down pulse signal MD in the third time period. Thus, the one or more down pulses of the down pulse signal DN are masked in the second time period. To summarize, the down pulse divider 206b, the third inverter 208c, the second flip-flop 210b, the fourth inverter 208d, and the second logic gate 212b operate in conjunction to mask the one or more down pulses of the down pulse signal DN.

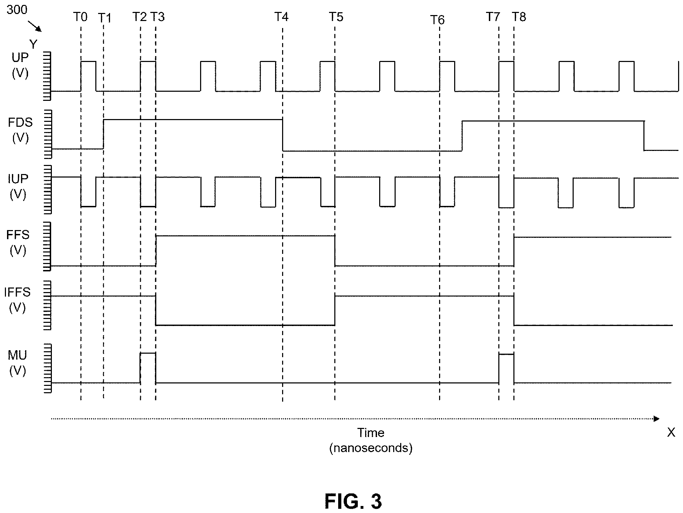

FIG. 3 represents a timing diagram 300 that illustrates an operation of the up pulse masking circuit 202 of the pulse masking circuit 110 of FIG. 2 in accordance with an embodiment of the present disclosure. The up pulse masking circuit 202 may receive the up pulse signal UP and output the masked-up pulse signal MU. The X-axis of the timing diagram 300 may indicate time in nanoseconds and the Y-axis of the timing diagram 300 may indicate a voltage level in volts.

For the sake of ongoing discussion, the predefined number of cycles of the up pulse signal UP is assumed as "6", thus the masking value is "3". As a result, the up pulse masking circuit 202 is configured to mask 5 up pulses of every 6 cycles of the up pulse signal UP. Time period T0-T6 indicates the first 6 cycles of the up pulse signal UP. Additionally, the succeeding cycle of the up pulse signal UP begins at time instance T6. At the time instance T1, the up pulse divider 206a may assert the first divider signal FDS from a logic low state to a logic high state based on the masking value and the up pulse signal UP. The first divider signal FDS is asserted at the time instance T1 due to propagation delay that occurs in the pulse masking circuit 110 in real-time.

The first divider signal FDS may be asserted by the up pulse divider 206a for 3 up pulses of the up pulse signal UP as the masking value is "3". Thus, the first divider signal FDS transitions from the logic high state to the logic low state at the time instance T4. The first flop signal FFS is generated by the first flip-flop 210a based on the first divider signal FDS and the inverted up pulse signal IUP. The inverted up pulse signal IUP corresponds to the inverted version of the up pulse signal UP. As a result, the first flop signal FFS transitions from a logic low state to a logic high state at the time instance T3 when the first divider signal FDS is at the logic high state and the inverted up pulse signal IUP transitions from a logic low state to a logic high state. In other words, the first flop signal FFS is asserted based on a rising edge of the inverted up pulse signal IUP and the logic high state of the first divider signal FDS. Although, it is illustrated that the first flop signal FFS is asserted at the time instance T3, in various embodiments, the first flop signal FFS may be asserted after the time instance T3 and prior to the succeeding rising edge of the up pulse signal UP due to the propagation delay. The inverted first flop signal IFFS corresponds to the inverted version of the first flop signal FFS. As a result, the inverted first flop signal IFFS transitions from a logic high state to a logic low state at the time instance T3 when the first flop signal FFS transitions from the logic low state to the logic high state. Although, it is illustrated that the inverted first flop signal IFFS is asserted at the time instance T3, in various embodiments, the inverted first flop signal IFFS may be asserted after the time instance T3 and prior to the succeeding rising edge of the up pulse signal UP due to the propagation delay.

The first flop signal FFS is de-asserted from the logic high state to the logic low state at the time instance T5 based on the rising edge of the inverted up pulse signal IUP and the logic low state of the first divider signal FDS.

The masked-up pulse signal MU is output by the first logic gate 212a based on the AND operation performed on the up pulse signal UP, the first divider signal FDS, and the inverted first flop signal IFFS. Thus, the masked-up pulse signal MU is asserted from the logic low state to the logic high state at the time instance T2 based on the up pulse signal UP transitioning from the logic low state to the logic high state, and the first divider signal FDS and the inverted first flop signal IFFS being at the logic high state. Further, the masked-up pulse signal MU is maintained at the logic high state until the time instance T3. Furthermore, at the time instance T3, the masked-up pulse signal MU is de-asserted from the logic high state to the logic low state based on the transition of the up pulse signal UP and the inverted first flop signal IFFS, from the logic high state to the logic low state. Thus, for 6 up pulses during time period T0-T6, the masked-up pulse signal MU includes one unmasked-up pulse. Further, the logic state of the masked-up pulse signal MU remains at the de-asserted state (e.g., a logic low state), until the first divider signal FDS, the inverted first flop signal IFFS, and the up pulse signal UP are asserted (e.g., in the logic high states), simultaneously.

Similarly, during time period T7-T8, the up pulse signal UP, the first divider signal FDS, and the inverted first flop signal IFFS are at logic high states. As a result, the masked-up pulse signal MU is asserted from the logic low state to the logic high state at the time instance T7 and the masked-up pulse signal MU is maintained at the logic high state until the time instance T8.

The transitions of various signals illustrated in FIG. 3 (such as the first divider signal FDS, the up pulse signal UP, the inverted up pulse signal IUP, the first flop signal FFS, and the inverted first flop signal IFFS) are illustrated without a set up time associated with each signal to make the illustrations concise and clear and should not be considered as a limitation of the present disclosure.

Although the timing diagram 300 illustrates the operation of the up pulse masking circuit 202, the transition of signals of the down pulse masking circuit 204 at various time instances are analogous to those of up pulse masking circuit 202 and thus will be understood by a person skilled in the art.

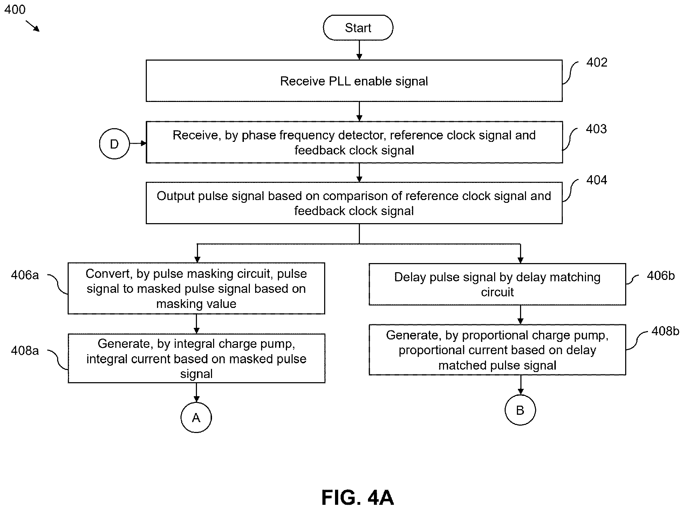

FIGS. 4A-4C, collectively, represents a flowchart 400 that illustrates a method of operating the dual-path PLL 104 of FIG. 2 in accordance with an embodiment of the present disclosure.

Referring to FIG. 4A, at step 402, the PLL enable signal PE may be received by the dual-path PLL 104. At step 403, the reference clock signal RC and the feedback clock signal FC may be received by the phase-frequency detector 108 based on the reception of the PLL enable signal PE. The phase-frequency detector 108 may receive the reference clock signal RC from the clock generator 102 and the feedback clock signal FC from the frequency divider 124. At step 404, the pulse signal PL may be outputted by the phase-frequency detector 108 based on the comparison of the reference clock signal RC and the feedback clock signal FC.

Steps 406a, 408a, 410a, and 412a are executed by the integral path of the dual-path PLL 104 and steps 406b, 408b, 410b, and 412b are executed by the proportional path of the dual-path PLL 104. At step 406a, the pulse signal PL may be converted to the masked pulse signal MP by the pulse masking circuit 110. The pulse masking circuit 110 may receive the pulse signal PL from the phase-frequency detector 108. The masked pulse signal MP includes one or more masked pulses and one or more unmasked pulses of the pulse signal PL. Additionally, the masked pulse signal MP may correspond to at least one of the masked-up pulse signal MU and the masked-down pulse signal MD. At step 408a, the integral current CI may be generated by the integral charge pump 112 based on the masked pulse signal MP. The average current value of the integral current CI reaches the desired value over a predefined number of cycles of the pulse signal PL based on the masking value of the dual-path PLL 104.

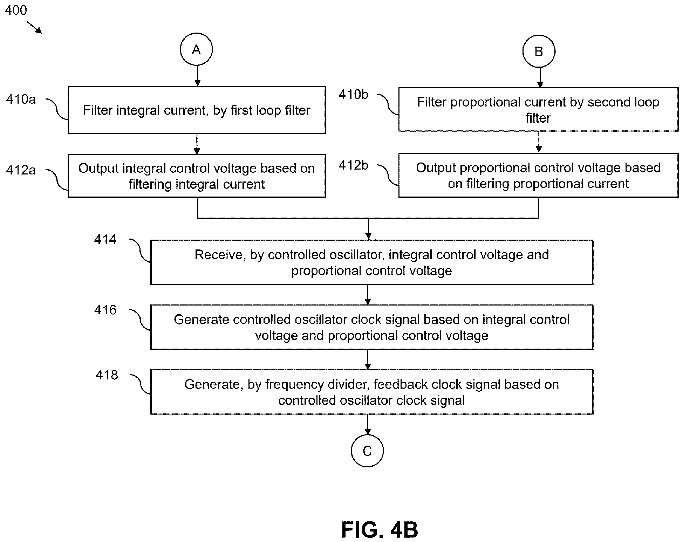

Referring to FIG. 4B, at step 410a, the integral current CI may be filtered by the first loop filter 114. At step 412a, the integral control voltage IV may be outputted by the first loop filter 114 based on filtering the integral current CI.

Referring back to FIG. 4A, at step 406b, the pulse signal PL may be delayed by the delay matching circuit 116 to output the delay matched pulse signal DP. At step 408b, the proportional current PI may be generated by the proportional charge pump 118 based on the delay matched pulse signal DP.

Referring again to FIG. 4B, at step 410b, the proportional current PI may be filtered by the second loop filter 120. At step 412b, the proportional control voltage PV may be outputted by the second loop filter 120 based on filtering the proportional current PI.

At step 414, the integral control voltage IV and the proportional control voltage PV may be received by the controlled oscillator 122 from the first loop filter 114 and the second loop filter 120, respectively. At step 416, the controlled oscillator clock signal VC may be generated by the controlled oscillator 122 based on the integral control voltage IV and the proportional control voltage PV. Additionally, the generated controlled oscillator clock signal VC may be provided to the functional circuit 106 and the frequency divider 124. At step 418, the feedback clock signal FC may be generated by the frequency divider 124 based on the controlled oscillator clock signal VC. Further, the feedback clock signal FC may be provided to the phase-frequency detector 108.

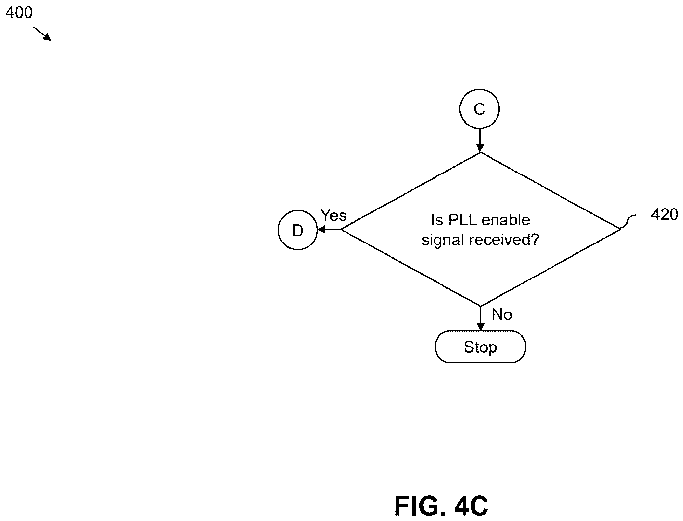

Referring to FIG. 4C, at step 420, it is determined whether the PLL enable signal PE is received by the dual-path PLL 104 based on the generation of the controlled oscillator clock signal VC. Further, steps 402-418 are repeated based on the determination that the PLL enable signal PE is received by the dual-path PLL 104. The process is halted based on the determination that the dual-path PLL 104 fails to receive the PLL enable signal PE.

In the present disclosure, the terms "assert" and "de-assert" are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one. Each signal described herein may be designed as positive or negative logic, where negative logic can be indicated by an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals. Additionally, a logic high state may be 2.4 volts or 5 volts while a logic low state may be 0 volts or less than 0 volts.

The dual-path PLL 104 of the present disclosure includes the integral charge pump 112 that operates with a higher current rating (e.g., five times, ten times, fifteen times, or twenty times greater) than conventional integral charge pumps thereby preventing sub-threshold operation of the dual-path PLL 104. As a result, up/down currents (e.g., the sourced current/the drained current) are beyond the sub-threshold regions resulting in an improved reference spur performance of the dual-path PLL 104 in comparison to conventional PLLs. Further, the integral charge pump 112 has a robust design as compared to conventional integral charge pumps. Additionally, the average value of the integral current CI of the dual-path PLL 104 is lower (e.g., five times, ten times, fifteen times, or twenty times lower) than the value of the proportional current PI thereby achieving optimal peaking in the dual-path PLL 104. As a result, jitters in the controlled oscillator clock signal VC are reduced and a phase offset of the dual-path PLL 104 is low in comparison to conventional dual-path PLLs. In other words, a phase difference between the controlled oscillator clock signal VC and the reference clock signal RC is minimal. In certain embodiments, the design of the proportional charge pump 118 may be identical to the integral charge pump 112. Based on the design of the proportional charge pump 118, the desired bandwidth may be achieved in the dual-path PLL 104. Thus, a complexity of designing the integral charge pump 112 and the proportional charge pump 118 is reduced. As the pulse masking circuit 110 is implemented using digital circuitry over analog circuitry, fluctuations in the masked pulse signal MP may be negligible.

A dual-path phase-locked loop (PLL) is disclosed. The dual-path PLL converts, based on a masking value, a pulse signal to a masked pulse signal such that the masked pulse signal comprises one or more unmasked pulses and one or more masked pulses of the pulse signal. An integral current is generated, based on the masked pulse signal in a manner such that that an average current value of the integral current reaches a desired value over a predefined number of cycles of the pulse signal and an optimal peaking in the dual-path PLL is achieved.

While various embodiments of the present disclosure have been illustrated and described, it will be clear that the present disclosure is not limited to these embodiments only. Numerous modifications, changes, variations, substitutions, and equivalents will be apparent to those skilled in the art, without departing from the spirit and scope of the present disclosure, as described in the claims. Further, unless stated otherwise, terms such as "first" and "second" are used to arbitrarily distinguish between the elements such terms describe. Thus, these terms are not necessarily intended to indicate temporal or other prioritization of such elements. The term "coupled" may refer to at least one of direct or indirect coupling that may not necessarily be by way of mechanical or any physical means. Further, a system or method that "comprises", "has", or "includes" one or more elements possesses those one or more elements but is not limited to possessing only those one or more elements.

A dual-path phase-locked loop (PLL) is disclosed. The dual-path PLL converts, based on a masking value, a pulse signal to a masked pulse signal such that the masked pulse signal comprises one or more unmasked pulses and one or more masked pulses of the pulse signal. An integral current is generated, based on the masked pulse signal in a manner such that that an average current value of the integral current reaches a desired value over a predefined number of cycles of the pulse signal and an optimal peaking in the dual-path PLL is achieved.

In an embodiment of the present disclosure, a dual-path phase-locked loop (PLL) is disclosed. The dual-path PLL may comprise a phase-frequency detector that may be configured to output a pulse signal. The dual-path PLL may further comprise a pulse masking circuit that may be coupled to the phase-frequency detector, wherein the pulse masking circuit may be configured to convert, based on a masking value, the pulse signal to a masked pulse signal such that the masked pulse signal may comprise one or more unmasked pulses and one or more masked pulses. The dual-path PLL may further comprise an integral charge pump coupled to the pulse masking circuit, wherein the integral charge pump may be configured to generate, based on the masked pulse signal, an integral current.

In some embodiments, the pulse masking circuit may be further configured to mask, based on the masking value, one or more pulses of the pulse signal to convert the pulse signal to the masked pulse signal.

In some embodiments, the dual-path PLL may further comprise a proportional charge pump coupled to the phase-frequency detector. The proportional charge pump may be configured to receive a delay matched pulse signal. The delay matched pulse signal may be a delayed version of the pulse signal. The proportional charge pump may be further configured to generate a proportional current based on the delay matched pulse signal.

In some embodiments, a bandwidth of the dual-path PLL may be controlled based on the proportional current.

In some embodiments, a current rating associated with each of the integral charge pump and the proportional charge pump may be identical.

In some embodiments, the dual-path PLL may further comprise a delay matching circuit, wherein the delay matching circuit may couple the phase-frequency detector and the proportional charge pump. The delay matching circuit may be configured to receive the pulse signal from the phase-frequency detector and delay the pulse signal. The delay matching circuit may be further configured to output the delay matched pulse signal upon delaying the pulse signal such that the proportional charge pump receives the delay matched pulse signal when the integral charge pump receives the masked pulse signal.

In some embodiments, the dual-path PLL may further comprise a first loop filter that may be coupled to the integral charge pump, wherein the first loop filter may be configured to receive the integral current. The first loop filter may be further configured to filter the integral current. The first loop filter may be further configured to output an integral control voltage based on the filtering of the integral current.

In some embodiments, the dual-path PLL may further comprise a second loop filter that may be coupled to the proportional charge pump, wherein the second loop filter may be configured to receive the proportional current. The second loop filter may be further configured to filter the proportional current. The second loop filter may be further configured to output a proportional control voltage based on the filtering of the proportional current.

In some embodiments, the dual-path PLL may further comprise a controlled oscillator, wherein the controlled oscillator may be configured to receive an integral control voltage and a proportional control voltage. The integral control voltage and a proportional control voltage may be received based on filtering of the integral current and the proportional current, respectively. The controlled oscillator may be further configured to generate a controlled oscillator clock signal based on the integral control voltage and the proportional control voltage.

In some embodiments, the dual-path PLL may further comprise a frequency divider coupled to the phase-frequency detector and the controlled oscillator. The frequency divider may be configured to receive the controlled oscillator clock signal. The frequency divider may be further configured to divide a frequency of the controlled oscillator clock signal by a division factor of the frequency divider. The frequency divider may be further configured to generate a feedback clock signal based on the division of the frequency of the controlled oscillator clock signal.

In some embodiments, the phase-frequency detector may be further configured to receive the feedback clock signal from the frequency divider and a reference clock signal, wherein the phase-frequency detector may generate the pulse signal based on a phase difference between the reference clock signal and the feedback clock signal.

In some embodiments, the pulse masking circuit may comprise a pulse divider that may be configured to receive the pulse signal. The pulse divider may be further configured to generate a divider signal based on the pulse signal and the masking value. The pulse masking circuit may be further configured to output the divider signal.

In some embodiments, the pulse masking circuit may further comprise a first inverter that may be configured to receive the pulse signal. The first inverter may be further configured to invert the pulse signal. The first inverter may be further configured to output an inverted pulse signal based inverting the pulse signal.

In some embodiments, the pulse masking circuit may further comprise a flip-flop, wherein the flip-flop may be coupled to the pulse divider and the first inverter. The flip-flop may be configured to receive the divider signal as a data input and the inverted pulse signal as a clock input. The flip-flop may be further configured to output a flop signal such that the flop signal may be asserted based on a rising edge of the inverted pulse signal and an asserted state of the divider signal.

In some embodiments, the pulse masking circuit may further comprise a second inverter that may be coupled to the flip-flop. The second inverter may be configured to receive the flop signal. The second inverter may be further configured to invert the flop signal. The second inverter may be further configured to output an inverted flop signal based on inverting the flop signal.

In some embodiments, the pulse masking circuit may further comprise a logic gate coupled to the phase-frequency detector, the pulse divider, and the second inverter. The logic gate may be configured to receive the pulse signal, the divider signal, and the inverted flop signal as inputs. The logic gate may be further configured to perform an AND operation based on the inputs. The logic gate may be further configured to output the masked pulse signal based on the AND operation.

In some embodiments, the masking value may be based on the predefined number of cycles.

In some embodiments, the pulse signal may be an up pulse signal.

In some embodiments, the pulse signal may be a down pulse signal.

In an embodiment of the present disclosure, a method is disclosed. The method may further comprise generating a pulse signal, by a phase-frequency detector of a dual-path phase-locked loop (PLL). The method may further comprise converting, by a pulse masking circuit of the dual-path PLL, the pulse signal to a masked pulse signal based on a masking value. The masked pulse signal may comprise one or more unmasked pulses and one or more masked pulses. The method may further comprise generating, by an integral charge pump of the dual-path PLL, based on the masked pulse signal.

## Claims

1. A dual-path phase-locked loop, PLL, comprising:
a phase-frequency detector configured to output a pulse signal;
a pulse masking circuit coupled to the phase-frequency detector, wherein the pulse masking circuit is configured to convert, based on a masking value, the pulse signal to a masked pulse signal such that the masked pulse signal comprises one or more unmasked pulses and one or more masked pulses; and
an integral charge pump coupled to the pulse masking circuit, wherein the integral charge pump is configured to generate, based on the masked pulse signal, an integral current.

2. The dual-path PLL of claim 1, wherein to convert the pulse signal to the masked pulse signal, the pulse masking circuit is further configured to mask based on the masking value, one or more pulses of the pulse signal.

3. The dual-path PLL of claim 1 or 2, further comprising a proportional charge pump coupled to the phase-frequency detector, wherein the proportional charge pump is configured to:
receive a delay matched pulse signal, wherein the delay matched pulse signal is a delayed version of the pulse signal such that the proportional charge pump receives the delay matched pulse signal when the integral charge pump receives the masked pulse signal; and
generate a proportional current based on the delay matched pulse signal.

4. The dual-path PLL of claim 3, wherein a bandwidth of the dual-path PLL is controlled based on the proportional current.

5. The dual-path PLL of claim 3 or 4, wherein a current rating associated with each of the integral charge pump and the proportional charge pump is identical.

6. The dual-path PLL of any of claims 3 to 5, further comprising a delay matching circuit, wherein the delay matching circuit couples the phase-frequency detector and the proportional charge pump, and wherein the delay matching circuit is configured to:
receive the pulse signal from the phase-frequency detector;
delay the pulse signal; and
output the delay matched pulse signal upon delaying the pulse signal such that the proportional charge pump receives the delay matched pulse signal when the integral charge pump receives the masked pulse signal.

7. The dual-path PLL of any of claims 3 to 6, further comprising a first loop filter coupled to the integral charge pump, wherein the first loop filter is configured to:
receive the integral current;
filter the integral current; and
output an integral control voltage based on the filtering of the integral current.

8. The dual-path PLL of any of claims 3 to 7, further comprising a second loop filter coupled to the proportional charge pump, wherein the second loop filter is configured to:
receive the proportional current;
filter the proportional current; and
output a proportional control voltage based on the filtering of the proportional current.

9. The dual-path PLL of any of claims 3 to 8, further comprising a controlled oscillator, wherein the controlled oscillator is configured to:
receive an integral control voltage and a proportional control voltage, wherein the integral control voltage and the proportional control voltage are received based on filtering of the integral current and the proportional current, respectively; and
generate a controlled oscillator clock signal based on the integral control voltage and the proportional control voltage.

10. The dual-path PLL of claim 9, further comprising a frequency divider coupled to the phase-frequency detector and the controlled oscillator, wherein the frequency divider is configured to:
receive the controlled oscillator clock signal;
divide a frequency of the controlled oscillator clock signal by a division factor of the frequency divider; and
generate a feedback clock signal based on the division of the frequency of the controlled oscillator clock signal.

11. The dual-path PLL of claim 10, wherein the phase-frequency detector is further configured to receive the feedback clock signal from the frequency divider and a reference clock signal, and wherein the phase-frequency detector generates the pulse signal based a phase difference between the reference clock signal and the feedback clock signal.

12. The dual-path PLL of any preceding claim, wherein the pulse masking circuit comprises a pulse divider that is configured to:
receive the pulse signal;
generate a divider signal based on the pulse signal and the masking value; and
output the divider signal.

13. The dual-path PLL of claim 12, wherein the pulse masking circuit further comprises a first inverter that is configured to:
receive the pulse signal;
invert the pulse signal; and
output an inverted pulse signal based on inverting the pulse signal.

14. The dual-path PLL of claim 13, wherein the pulse masking circuit further comprises a flip-flop, wherein the flip-flop is coupled to the pulse divider and the first inverter, and wherein the flip-flop is configured to:
receive the divider signal as a data input and the inverted pulse signal as a clock input; and
output a flop signal such that the flop signal is asserted based on a rising edge of the inverted pulse signal and an asserted state of the divider signal.

15. A method comprising:
outputting, by a phase-frequency detector of a dual-path phase-locked loop, PLL, a pulse signal;
converting, by a pulse masking circuit of the dual-path PLL, the pulse signal to a masked pulse signal based on a masking value, wherein the masked pulse signal comprises one or more unmasked pulses and one or more masked pulses; and
generating, by an integral charge pump of the dual-path PLL based on the masked pulse signal.
